(19)

Europäisches
Patentamt

European
Patent Office

Office européen
des brevets

(11) **EP 1 390 157 B1**

(12) **EUROPEAN PATENT SPECIFICATION**

(45) Date of publication and mention
of the grant of the patent:
**30.04.2008 Bulletin 2008/18**

(21) Application number: **01923924.3**

(22) Date of filing: **05.04.2001**

(51) Int Cl.:
***C23C 14/56*** *(2006.01)*

(86) International application number:
**PCT/IL2001/000326**

(87) International publication number:
**WO 2001/076768 (18.10.2001 Gazette 2001/42)**

(54) **METHOD FOR TEMPERATURE CONTROLLED VAPOR DEPOSITION ON A SUBSTRATE**

VERFAHREN ZUR TEMPERATURGESTEUERTEN DAMPFABSCHEIDUNG AUF EINEM
SUBSTRAT

PROCEDE DE DEPOT PAR EVAPORATION SOUS VIDE EN TEMPERATURE CONTROLEE SUR
UN SUBSTRAT

(84) Designated Contracting States:
**AT BE CH CY DE DK ES FI FR GB GR IE IT LI LU
MC NL PT SE TR**

(43) Date of publication of application:
**25.02.2004 Bulletin 2004/09**

(73) Proprietor: **Acktar Ltd.
82000 Kiryat Gat (IL)**

(72) Inventors:
• **KATSIR, Dina
84770 Beer Sheva (IL)**
• **FINKELSTEIN, Zvi
25243 Asseret (IL)**
• **TARTAKOVSKY, Israel
82218 Kiryat Gat (IL)**

(74) Representative: **Colens, Alain M.G.M.
Office Hanssens Colens
Square Marie Louise 40
Bte 19
1000 Bruxelles (BE)**

(56) References cited:
EP-A- 0 730 045          WO-A-89/10430
US-A- 4 844 009          US-A- 4 970 626
US-A- 5 239 026          US-A- 5 709 957
US-A- 5 803 976          US-A- 5 997 956

• **PATENT ABSTRACTS OF JAPAN vol. 009, no. 028
(C-264), 6 February 1985 (1985-02-06) & JP 59
173266 A (FUJI SHASHIN FILM KK), 1 October
1984 (1984-10-01)**
• **CASEY F ET AL: "Properties of metallized film in
a free span web metallizer" PROC ANNU TECH
CONF SOC VAC COATERS; PROCEEDINGS,
ANNUAL TECHNICAL CONFERENCE - SOCIETY
OF VACUUM COATERS 1999 SOC OF VACUUM
COATERS, ALBUQUERQUE, NM, USA, 1999,
pages 480-483, XP009064032**
• **PROFESOR GOD: "Skriptum Wärmetechnik"
SKRIPTUM WÄRMETECHNIK, June 2000
(2000-06), pages 159-159, XP002374265 Leoben,
Austria, Institut für Wärmetechnik,
Industrieofenbau und Energiewirtschaft
Montanuniversität Leoben**

EP 1 390 157 B1

## Description

### FIELD OF THE INVENTION

The present invention relates generally to a vapor deposition method. The present invention relates in particular to a vapor deposition method in which the substrate temperature is controlled.

### BACKGROUND OF THE INVENTION

Vacuum vapor deposition is a known method for increasing the surface areas of foil electrodes. A heat load, produced by condensation, raises the temperature of a substrate on which the vapor is deposited. In order to maintain the substrate at an optimum temperature for deposition, cooling is required.

US Patent No. 4,970,626 to Kakinoki et al., describes a method for producing an electrolytic capacitor by vapor deposition, in which the substrate is supported by a drum. The drum also serves as a cooling element, dissipating heat by conduction. However, conduction cooling of the substrate has disadvantages. According to "Properties of Metallized Film in a Free Span Web Metallizer," by F. Casey et al., 1999 Society of Vacuum Coaters 505/856-7188, pp. 480-483, during vapor deposition, high heat production causes the substrate to expand. Yet, frictional forces between the substrate and the drum prevent the expansion. As a result, the substrate wrinkles.

Free-span vapor deposition processes have been in use since the 1970's and avoid the problem of wrinkles. For example, US Patent No. 5,288,515, to Nakamura et al. describes a free-span, vapor deposition process. But without the cooling drum, heat dissipation remains a problem.

Since conductive cooling with a cooling drum gives rise to substrate-foil wrinkles, and since convective cooling is inapplicable in a vacuum chamber, radiation heat dissipation is the only avenue that remains. Radiation heat dissipation can take place from the side of the substrate that is not being vapor-deposited. However, the effectiveness of radiation cooling depends on the thermal emittance of the substrate, which may be too low. For example, the thermal emittance of an aluminum substrate is approximately 0.02, too low to provide effective heat dissipation by radiation.

It is an aim of the present invention to provide a method for vapor deposition at a controlled substrate temperature.

There is thus provided, in accordance with a preferred embodiment of the present invention, a method of controlling the temperature of a metallic foil substrate as defined in claim 1.

Further in accordance with a preferred embodiment of the present invention, the first step includes forming, by vapor deposition on the first side of the substrate, a thin layer of the greater thermal emittance substance.

Additionally, in accordance with a preferred embodiment of the present invention, the layer on the first side is operative to radiate excess heat away from the layer on the second side, in addition to radiating heat away from the substrate.

Further in accordance with a preferred embodiment of the present invention, the substance of the second side is a preselected high thermal emittance substance.

Additionally, in accordance with a preferred embodiment of the present invention, in the first and second steps the preselected substances are the same.

Alternatively, in accordance with the present invention, the method further includes a first-side step of forming, by vapor deposition onto the layer formed on the first side of the substrate, a further layer of the preselected substance thereon.

Additionally, in accordance with the present invention, the method includes repeating the first-side step until a layer of a desired thickness is formed on the first side. Further in accordance with the present invention, the method includes a second-side step of forming, by vapor deposition onto the layer formed on the second side of the substrate, a further layer of the preselected substance thereon.

Further in accordance with the present invention, the method includes repeating the second-side step until a layer of a desired thickness is formed on the second side.

Additionally, in accordance with the present invention, the method includes a step of varying at least one of the following: the thickness of the layer on the first side, the thickness of the layer on the second side, the rate of vapor deposition onto the first side, and the rate of vapor deposition onto the second side.

Further in accordance with a preferred embodiment of the present invention, the method includes cooling the substrate by radiation between the substrate and a cold element, i.e. an element which is colder relative to the substrate.

Additionally, in accordance with a preferred embodiment of the present invention, the method includes moving the substrate on free-span apparatus for vapor deposition.

Further in accordance with a preferred embodiment of the present invention, the method includes varying the substrate speed to control the substrate temperature.

Additionally, in accordance with a preferred embodiment of the present invention, the method includes cooling the substrate by conduction to a cold element of the free-span apparatus.

Alternatively, in accordance with the present invention, the method includes supporting the substrate on stationary apparatus for vapor deposition.

Further in accordance with the present invention, the method includes cooling the substrate by conduction to a cold element of the stationary apparatus.

Additionally, in accordance with the present invention, vapor deposition includes reactive vapor deposition.

ACKNOWLEDGMENT OF CITED PRIOR ART

EP0730045. A Zn-Mg binary coating layer formed on a steel sheet has a tri-layered structure in which the first layer is composed of a Zn-Mg alloy having ≤0.5 wt.% Mg, the second layer is composed of a Zn-Mg alloy having ≥7 wt. % Mg, and the third layer is composed of a Zn-Mg alloy having ≤0.5 wt.% Mg. The coating layer may have alternatively an analogous penta-layered structure.

JP59173266. Formation of thin films on both surfaces of a supporting body wound into a roll in a single step, by constituting a vacuum tank with a plurality of (e.g. 6) sputtering chambers, and inhibiting the inflow of contaminating gases.

W08910430. Vacuum sputter deposition systems include a compactly constructed mobile roll coater, having a winding configuration which maximizes the area available for positioning source targets at desirable angles relative to the roll coater chill drums over which the roll to be coated moves. Typical sputtering materials are Cr, stainless steel, Ti, Al, Cur, brass, W, Mo, Au, Ag, Ta, and various alloys and compounds.

US4844009. A method and apparatus for vacuum coating of materials having a three-dimensional surface structure is disclosed that provides cooling, to prevent heat destruction of those materials during vacuum coating. The web is moved back and forth across the coating area, between rolls. A cooling film is rolled onto each roll with the web. As the web is unrolled, the film is unrolled and re-cooled before being rolled up again with the web.

## BRIEF DESCRIPTION OF THE DRAWINGS

The present invention will be more clearly understood from the accompanying detailed description and drawings, in which same number designations are maintained throughout the figures for similar elements and in which:

Fig. 1 is a schematic representation of a multi-stage, free-span, vapor deposition apparatus;
Fig. 2 is a schematic representation of a vapor deposition process of the apparatus of Fig. 1;
Fig. 3 is a schematic representation of a multi-stage, free-span, vapor deposition apparatus; and
Figs. 4A-4C are schematic representations of multi-stage, free-span, vapor deposition apparatus.

## DEFINITION OF TERMS

The present invention will be more clearly understood from the accompanying definitions:

1. High thermal emittance substance or layer: a substance or layer with an emittance greater than the emittance of the substrate. It is to be understood that whenever the term "high thermal emittance" of a substance is discussed herein, the high thermal emittance may be a result of the intrinsic emittance of the substance or a result of the condition of the surface of the substance. The emittance of the substance should typically be such that any degradation of desired properties of the substrate and/or one or more layers deposited thereon is prevented.

2. Thin layer: a layer thickness that does not cause the substrate's temperature to rise above a preselected maximum allowable temperature, for a given substrate and a given process.

## DETAILED DESCRIPTION OF THE PREFERRED EMBODIMENTS

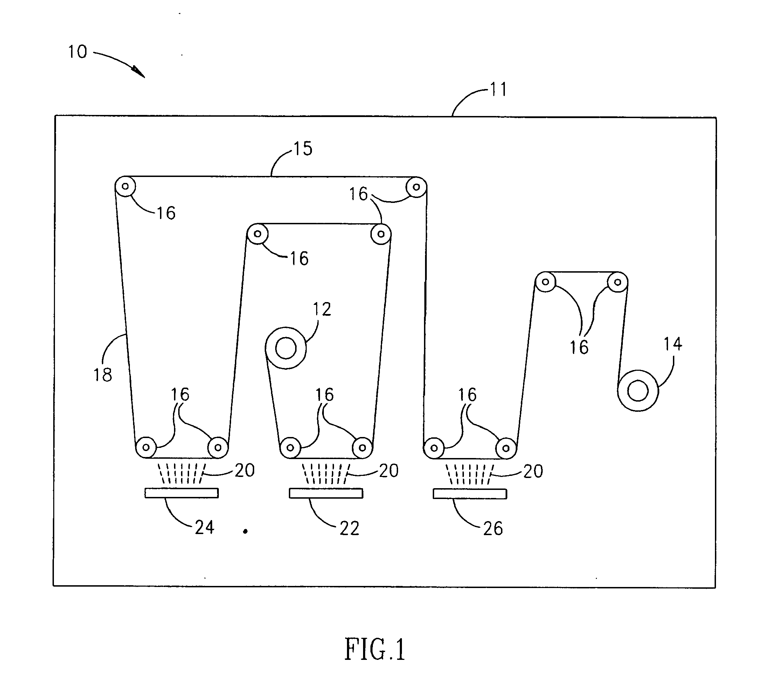

Reference is now made to Fig. 1, which is a schematic representation of multi-stage, free-span, vapor deposition apparatus 10. Preferably, apparatus 10 includes the following components:

a first spool 12, on which a substrate 18 is wound prior to vapor deposition, for unwinding and releasing substrate 18, for vapor deposition;
a second spool 14, for receiving substrate 18 following vapor deposition, and for winding substrate 18 thereon;
a plurality of guide rollers 16, located on a path 15, between first spool 12 and second spool 14, for guiding substrate 18;
two first-side, vapor deposition stations 22 and 26, located along path 15, arranged for vapor deposition of vapor 20 on a first side of substrate 18;
a second-side, vapor deposition station 24, located along path 15, between first-side vapor deposition stations 22 and 26, and arranged for vapor deposition of vapor 20 on a second side of substrate 18; and
a vacuum chamber 11, for housing the aforementioned components and for providing a vacuum for the process of apparatus 10.

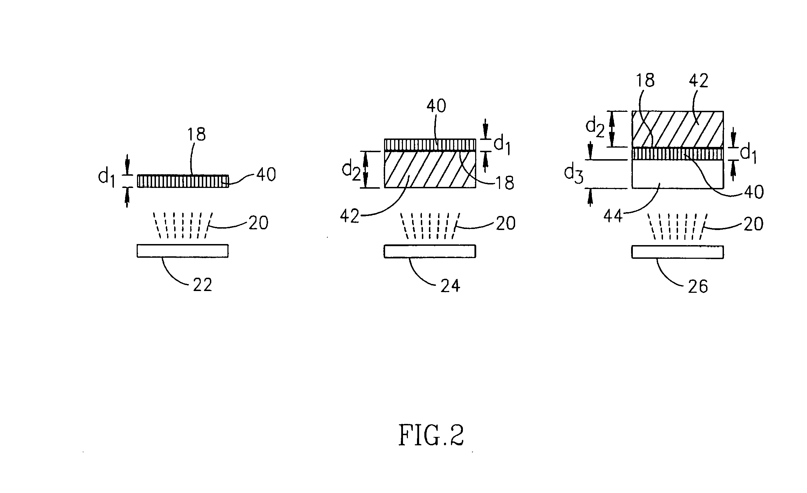

Reference is now made to Fig. 2, which is a schematic representation of a method of controlling the temperature of a low thermal emittance substrate during a process of vapor deposition thereon of a preselected, high thermal emittance substance, in accordance with a preferred embodiment of the present invention. Preferably, vapor deposition is performed in stages:

As a first stage, at station 22, a thin, first layer 40 of the preselected high thermal emissivity substance is applied, by vapor deposition, to a first side of substrate 18. First layer 40 has a thickness $d_1$, which may be, for example, 0.5 - 1.5 microns. Because the layer is thin, the amount of heat discharge, due to vapor deposition, is low. Thus, substrate 18 is heated to more than a first predetermined temperature, $T_1$, which is preferably controlled by the thickness of the thin, first layer. Alternatively, the first predetermined temperature may be controlled by other parameters, for example, vapor deposition rate.

As a second stage, at station 24, a relatively thick, second layer 42 of the preselected high thermal emittance substance is applied, by vapor deposition, to a second side of substrate 18. Second layer 42 has a thickness $d_2$, which may be, for example, 3.5-4 microns. First layer 40 is operative to radiate excess heat away from substrate 18 and from second layer 42, thereby to heat substrate 18 to no more than a second predetermined temperature, $T_2$. $T_1$ is close in value to $T_2$, as will be seen hereinbelow, in conjunction with Table 2.

Preferably, as a third stage, at station 26, a relatively thick, third layer 44 of the preselected high thermal emittance substance is applied, by vapor deposition, to the first side of substrate 18, onto first layer 40. Third layer 44 has a thickness $d_3$, which may be, for example, 2.5 - 3.5 microns. Preferably, $d_2 \approx d_1 + d_3$, so the thickness of the aggregate layer of the first side is substantially the same as the second layer. In this stage, second layer 42 is operative to radiate excess heat away from substrate 18 and from third layer 44, thereby to heat substrate 18 to no more than a third predetermined temperature, $T_3$. In accordance with a preferred embodiment of the present invention, $T_1$, $T_2$, and $T_3$ are generally close in value, as will be seen hereinbelow, in conjunction with Table 2. Alternatively, where coating on only one side of substrate 18 is desired, the third stage is not conducted.

Reference is now made to Tables 1 and 2, which together illustrate the advantage of the present invention, for a case wherein substrate 18 is 30 microns thick and is moving at a speed of 0.38 m/min with vapor being deposited at a rate of 1120 Å/s.

Table I illustrates an experiment in accordance with the prior art method, wherein layers that are 3.5 microns thick are applied, by vapor deposition, to the two sides of substrate 18. During the application of the first layer to the first side of substrate 18, substrate temperature rises to 415°C. However, during the application of the second layer to the second side of substrate 18, the first layer is available and is operative to radiate excess heat away from substrate 18 and from second layer 42, thereby to heat substrate 18 to no more than 295°C.

Table 2 illustrates an experiment in accordance with the present invention, wherein layers that are 3.5 microns thick are applied, in stages, by vapor deposition, to the two sides of substrate 18. During the first stage, thin layer 40, which is 1.25-microns thick is applied to the first side of substrate 18 and substrate temperature rises only to 312°C, since layer 40 is rather thin. During the second stage, layer 42 is applied to the second side of substrate 18 and substrate temperature rises only to 309°C, since layer 40 is operative to radiate excess heat away from substrate 18 and from second layer 42. During the third stage, layer 44 is applied to the first side of substrate 18, onto layer 40, and substrate temperature rises only to 258°C, since layer 42 is operative to radiate excess heat away from substrate 18 and from layer 44.

**TABLE 1**

| PRIOR ART VAPOR DEPOSITION | | | |
|---|---|---|---|
| **Substrate Side** | **Layer Thickness, Microns** | **Substrate Back-Side Thermal Emittance** | **Peak Substrate Temperature, °C** |
| **First Side** | 3.5 | 0.02 | 415 |
| **Second Side** | 3.5 | 0.70 | 295 |

**TABLE 2**

| VAPOR DEPOSITION IN ACCORDANCE WITH THE INVENTION | | | |
|---|---|---|---|
| Substrate Side | Layer Thickness, Microns | Substrate Back-Side Thermal Emittance | Peak Substrate Temperature, °C |
| First Side | 1.25 | 0.02 | 312 |
| Second Side | 3.5 | 0.50 | 309 |
| First Side | 2.25 | 0.70 | 268 |

Thus, in the experimental example of the present invention, peak substrate temperatures throughout a three-stage vapor deposition process did not rise above 312°C, whereas peak substrate temperature rose to 415°C in an experiment of the prior-art situation, for same substances, layer thickness, and substrate speed.

Reference is now made to Table 3, which illustrates a prior-art experiment for a substrate speed of 0.12 m/min, with vapor being deposited at a rate of 350 Å/s, and where the other conditions remain as in Table 1. As seen in Table 3, in order to achieve peak substrate temperatures similar to those of the present invention (Table 2), with prior-art technology, substrate speed must be reduced significantly. In the present example, it is reduced by more than a third, from 0.38 m/min to 0.12 m/min, thus slowing down the process.

**TABLE 3**

| PRIOR ART VAPOR DEPOSITION | | | |
|---|---|---|---|
| Substrate Side | Layer Thickness, Microns | Substrate Back-Side Thermal Emittance | Peak Substrate Temperature, °C |
| First Side | 3.5 | 0.02 | 310 |
| Second Side | 3.5 | 0.70 | 255 |

Reference is now made to Table 4, which illustrates an experiment in accordance with the present invention for the same vapor deposition rate (1120 Å/s) as in Table 2. The deposited layer is thinner with the substrate run at a speed of 0.96 m/min, about two and a half times faster than the substrate speed of 0.38 m/min of Table 2. All other conditions remain the same. As seen in Table 4, with the technology of the present invention, peak substrate temperatures remain relatively low even for the higher substrate speed.

**TABLE 4**

| VAPOR DEPOSITION IN ACCORDANCE WITH THE INVENTION | | | |
|---|---|---|---|
| Substrate Side | Layer Thickness, Microns | Substrate Back-Side Thermal Emittance | Peak Substrate Temperature, °C |
| First Side | 0.75 | 0.02 | 320 |
| Second Side | 1.5 | 0.40 | 320 |
| First Side | 0.75 | 0.60 | 250 |

In accordance with the present invention, substrate 18 may be a metallic foil, for example, aluminum foil. For example, the aluminum foil is about 30 microns in thickness and the layer thickness by vapor deposition is about 3 to 5 microns.

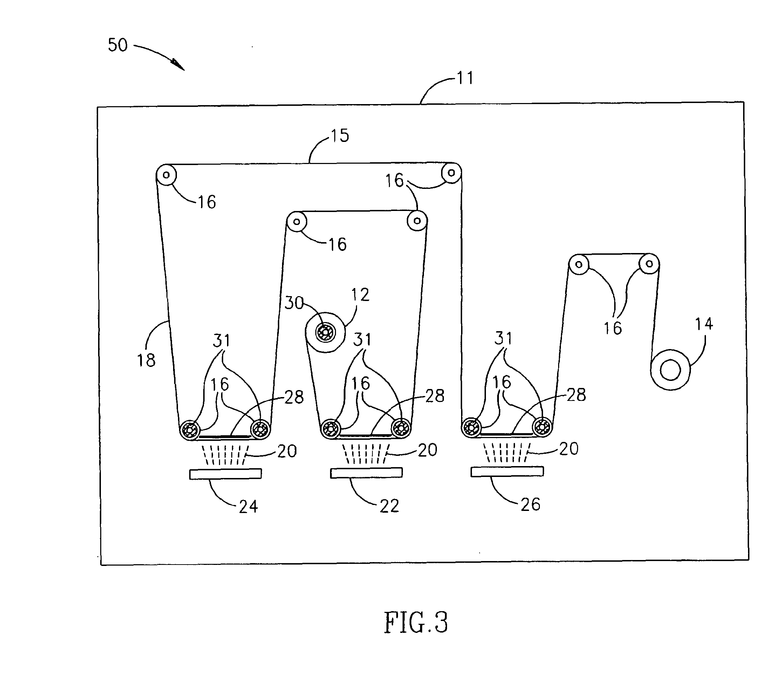

Vapor deposition stations 22, 24 and 26 (Figs. 1 and 3) are arranged for aluminum vapor reactive deposition, wherein the vapor includes a mixture of aluminum metal and oxygen. Alternatively, vapor deposition stations 22, 24 and 26 are arranged for titanium vapor reactive deposition, wherein the vapor includes a mixture of titanium metal and oxygen. Alternatively, vapor deposition stations 22, 24 and 26 are arranged for aluminum oxide vapor deposition. Alternatively, vapor deposition stations 22, 24 and 26 are arranged for titanium oxide vapor deposition, or of any suitable material, as known in the art.

Reference is now made to Fig. 3, which is a schematic representation of multi-stage, free-span, vapor deposition apparatus 50. Apparatus 50 includes at least one cold element 30, of a controlled cooling rate, preferably located within spool 12, for providing conductive heat removal to substrate 18. Alternatively, or additionally, a cold element 30 may be located within spool 14. Alternatively or additionally, cold elements 31, of a controlled cooling rate, may be located within guide rolls 16 at the vapor deposition stations, for providing conductive heat removal to substrate 18. Alternatively or additionally, cold elements 31 may be located within other guide rolls 16. Alternatively or additionally, at least one cold element 28, of a controlled cooling rate, may be located very close to the substrate at a vapor deposition station, on the side of the substrate opposite the vapor deposition station, for cooling the substrate during vapor deposition.

Cold elements 28, 30, and 31 of controlled cooling rates may be cooled by conventional, Rankin-like refrigeration cycles. Alternatively, they may be cooled by thermoelectric cooling.

Heat dissipation by radiation from substrate 18 to cold element 28 is described by the following expression:

$$Q_{dissipation} \propto \varepsilon_{18} \times \varepsilon_{28} \ (T_{18}^4 - T_{28}^4)$$

wherein, $Q_{dissipation}$ denotes the amount of heat transfer by radiation between substrate 18 and cold element 28, $\varepsilon_{18}$ and $\varepsilon_{28}$ denote the thermal emittances of substrate 18 and cold element 28, respectively, and $T_{18}$ and $T_{28}$ denote the absolute temperatures of substrate 18 and cold element 28, respectively. For effective heat dissipation, $\varepsilon_{18}$ and $\varepsilon_{28}$ should be high, so element 28 may be painted black, and the difference, $T_{18}^4 - T_{28}^4$ should be high, therefore $T_{28}$ is as low as possible. The method of heat dissipation with cold element 28 will be more effective at vapor deposition station 24, where $\varepsilon_{18}$ is relatively high, than at vapor deposition station 22, where $\varepsilon_{18}$ is relatively low.

The apparatus may be used also when only one-sided vapor deposition is needed. A thin, first layer is applied at vapor deposition station 22 (Figs. 1 and 3) in order to increase the thermal emittance of substrate 18, and a second layer of a desired thickness is then applied to the second side, wherein the thin first layer is operative to radiate excess heat away from substrate 18 and from the second layer.

More than three vapor stations and three vapor deposition stages may be used, thus reducing the heat load that needs to be dissipated in each stage, and gradually increasing the thermal emittance for heat dissipation, with each stage.

Alternatively, free-span, vapor deposition apparatus which has only two vapor deposition stations, for first-side and second-side vapor deposition, may be used. Vapor deposition is applied in two or more passes of substrate 18 through the apparatus. For example, substrate 18 may be run through the apparatus for a first, partial vapor deposit on both sides, and then again, for a final vapor deposition on both sides, immediately after the first run, or any time after the first run.

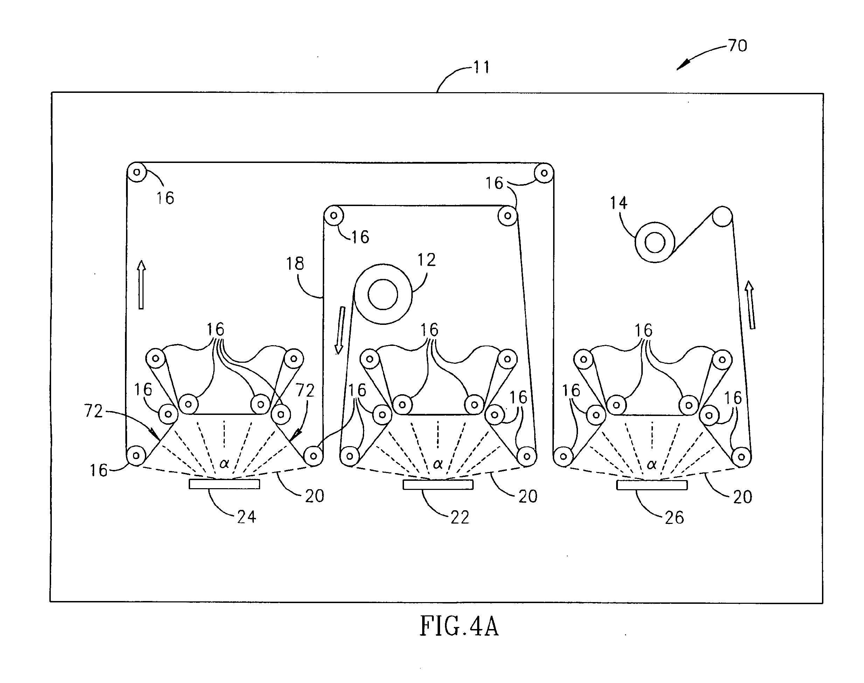

Reference is now made to Fig. 4A, which is a schematic representation of free-span, multi-stage, vapor deposition apparatus 70, for increased vapor deposition efficiency. Vapor deposition efficiency is normally defined as the ratio of the vapor mass deposited on the substrate to the total vapor mass evaporated for a given apparatus. Vapor distribution from a metallic source can be simulated using a modification of Lambert's law for a radiation source, as shown by vapor 20 of Fig. 4A. In order to minimize edge, or tangential losses, and increase the vapor deposition efficiency, guide rollers 16 of apparatus 70 are arranged so as to guide substrate 18 through a path 72 that collects rays of vapor 20 from a wide angle $\alpha$, which approaches 180°.

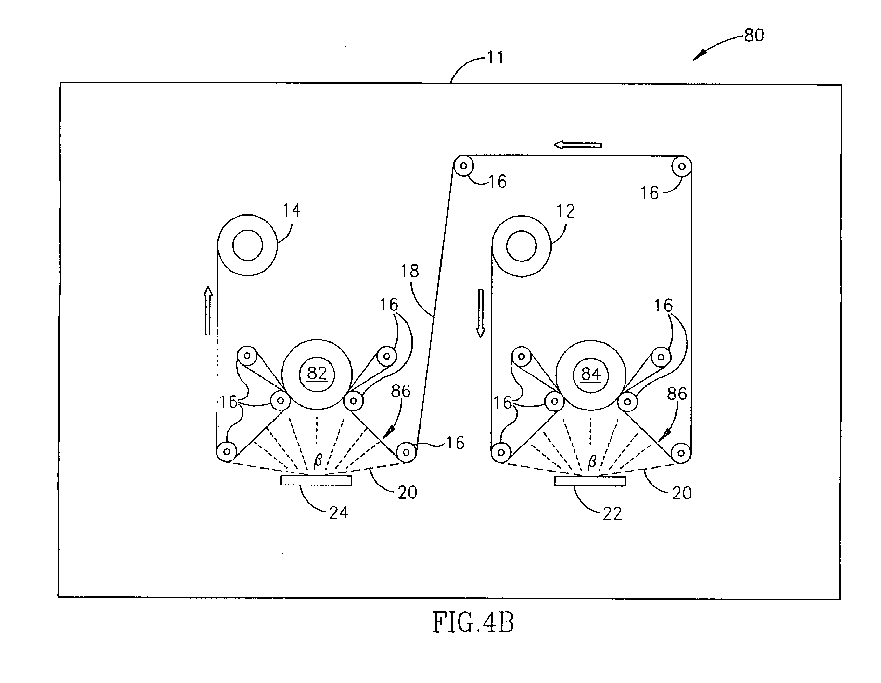

Reference is now made to Fig. 4B, which is a schematic representation of vapor deposition apparatus 80, for increased vapor deposition efficiency. In Fig. 4B, substrate 18 is supported by drums 82 and 84 and by guide rollers 16. In order to increase the vapor deposition efficiency, guide rollers 16 of apparatus 80 are arranged so as to guide substrate 18 through a path 86 that collects rays of vapor 20 from a wide angle $\beta$, which approaches 180°.

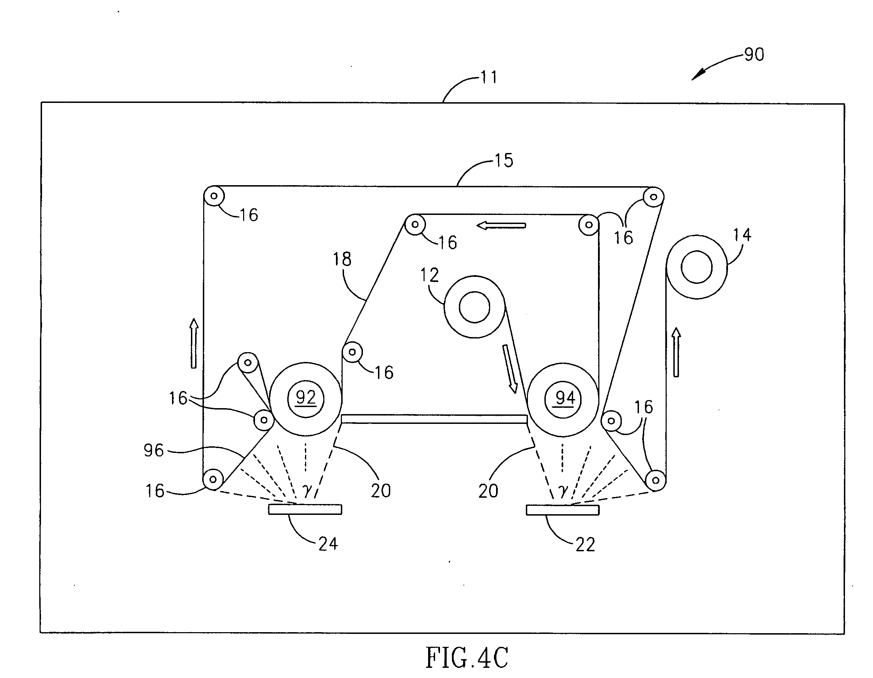

Reference is now made to Fig. 4C, which is a schematic representation of vapor deposition apparatus 90, for increased vapor deposition efficiency. In Fig. 4C, substrate 18 is supported by drums 92 and 94 and by guide rollers 16. In order to increase the vapor deposition efficiency, guide rollers 16 of apparatus 90 are arranged so as to guide substrate 18 through a path 96 that collects rays of vapor 20 from a wide angle $\gamma$.

It will be appreciated by persons skilled in the art, that the scope of the present invention is not limited to a substrate in foil form. The methods of vapor deposition and of vapor reactive deposition of the present invention may be applied to a substrate supported by apparatus other than the free-span apparatus. For example, vapor deposition, or vapor reactive deposition may be applied to a stationary substrate in a form of a chip, held, for example, in window-frame like apparatus, which may revolve on a hinge for vapor deposition of first and second sides.

It will be appreciated by persons skilled in the art, that the scope of the present invention is not limited to improving heat dissipation in vacuum deposition systems. The methods of vapor deposition and of vapor reactive deposition described herein above may be applied to achieve a desired surface roughness of a deposited substance, in addition to controlling the morphology of any second and additional layers deposited on a first thin layer.

It will be further appreciated by persons skilled in the art, that the scope of the present invention is not limited by what has been specifically shown and described hereinabove, merely by way of example. Rather, the scope of the invention is limited solely by the claims, which follow.

**Claims**

1. A method of controlling the temperature of a low thermal emittance metallic foil substrate (18) during a process of free-span vapor deposition thereon in a free-span vapor deposition apparatus (10), which includes:

   (a) a first step of forming, by vapor deposition, a layer (40) of a first preselected substance on a first side of the substrate (18), said layer having a greater thermal emittance than the substrate,
   (b) a second step of forming, by vapor deposition on a second side of the substrate 18, a layer (42) of a second preselected substance, wherein the layer on the first side is operative to radiate excess heat away from the substrate (18), thereby preventing heating of the substrate (18) to more than a predetermined temperature,

   and optionally (c) a third step of forming, by vapor deposition onto the layer formed on the first side of the substrate (18), at least one further layer (44) of a preselected substance thereon until a layer of a desired thickness is formed on the first side,
   **characterised in that** the vapor deposition of the first step (a) is selected from aluminum vapor reactive deposition, wherein the vapor includes a mixture of aluminium metal and oxygen, aluminum oxide vapor deposition, tantalum vapor reactive deposition, wherein the vapor includes a mixture of tantalum metal and oxygen, tantalum oxide vapor deposition, titanium vapor reactive deposition, wherein the vapor includes a mixture of titanium metal and oxygen, and titanium oxide vapor deposition.

2. A method according to claim 1, wherein the layer on the first side is further operative to radiate excess heat away from the layer on the second side, in addition to radiating heat away from the substrate.

3. A method according to claim 1, wherein the second preselected substance is a substance having a greater thermal emittance than the substrate.

4. A method according to claim 3, wherein said first and second preselected substances are the same.

5. A method according to claim 1 wherein in said third step said at least one further layer includes at least one further layer of said first preselected substance.

6. A method according to claim 1 and further including a second-side step of forming, by vapor deposition onto the layer formed on the second side of the substrate, a further layer of the preselected substance thereon.

7. A method according to claim 6 and further including repeating said second-side step until a layer of a desired thickness is formed on the second side.

8. A method according to claim 1 and further including a step of varying at least one of the following : the thickness of the layer on the first side, the thickness of the layer on the second side, the rate of vapor deposition onto the first side, and the rate of vapor deposition onto the second side.

9. A method according to claim 1 and further including cooling the substrate by thermal radiation from the substrate to a cold element.

10. A method according to claim 1 and further including moving the substrate on said free-span apparatus for vapor deposition.

11. A method according to claim 10 and further including varying the substrate speed to control the substrate temperature.

12. A method according to claim 10 and further including cooling the substrate by conduction to a cold element of the free-span apparatus.

13. A method according to claim 1 and further including supporting the substrate on stationary apparatus for vapor deposition.

14. A method according to claim 13 and further including cooling the substrate by conduction to a cold element of the stationary apparatus.

**15.** A method according to claim 1, wherein vapor deposition includes reactive vapor deposition.

**16.** A method according to claim 1, wherein said metallic foil is aluminum foil.

**17.** A method according to claim 1, wherein said vapor deposition is selected from aluminum vapor reactive deposition, aluminum oxide vapor deposition, tantalum vapor reactive deposition, tantalum oxide vapor deposition, titanium vapor reactive deposition, and titanium oxide vapor deposition.

**18.** A method according to claim 16, wherein said vapor deposition is selected from aluminum vapor reactive deposition, aluminum oxide vapor deposition, tantalum vapor reactive deposition, tantalum oxide vapor deposition, titanium vapor reactive deposition, and titanium oxide vapor deposition.

**Patentansprüche**

**1.** Ein Verfahren zur Steuerung der Temperatur eines metallischen Folien-Substrates (18) mit niedrigem thermischen Emissionsvermögen während eines frei beweglichen Dampfabscheidungsprozesses auf diese in einer frei beweglichen Aufdampfvorrichtung (10), das umfaßt:

(a) einen ersten Schritt der Erzeugung einer Schicht (40) einer ersten vorgegebenen Substanz auf einer ersten Seite des Substrates (18) mittels Dampfabscheidung, wobei die besagte Schicht ein größeres thermisches Emissionsvermögen als das Substrat besitzt,
(b) einen zweiten Schritt der Erzeugung einer Schicht (42) aus einer zweiten vorgegebenen Substanz auf einer zweiten Seite des Substrates (18) mittels Dampfabscheidung, wobei die Schicht auf der ersten Seite geeignet ist, überschüssige Wärme aus dem Substrat (18) abzustrahlen, wodurch eine Erwärmung des Substrates (18) auf eine höhere als eine vorgegebene Temperatur verhindert wird,

und optional (c) einen dritten Schritt der Erzeugung wenigstens einer weiteren Schicht (44) einer vorgegebenen Substanz mittels Dampfabscheidung auf die auf der ersten Seite des Substrates (18) erzeugte Schicht, bis eine Schicht mit einer gewünschten Dicke auf der ersten Seite erzeugt ist,
**dadurch gekennzeichnet, daß** der Dampfabscheidungsprozeß des ersten Schrittes (a) aus einem der nachfolgenden Verfahren ausgewählt wird: reaktive Aluminium-Bedampfung, wobei der Dampf eine Mischung aus Aluminiummetall und Sauerstoff beinhaltet, Aluminiumoxid-Bedampfung, reaktive Tantal-Bedampfung, wobei der Dampf eine Mischung aus Tantalmetall und Sauerstoff beinhaltet, Tantaloxid-Bedampfung, reaktive Titan-Bedampfung, wobei der Dampf eine Mischung aus Titanmetall und Sauerstoff beinhaltet, und Titanoxid-Bedampfung.

**2.** Ein Verfahren gemäß Anspruch 1, bei dem die Schicht auf der ersten Seite zusätzlich zur Abstrahlung von Wärme aus dem Substrat weiterhin geeignet ist, überschüssige Wärme aus der Schicht auf der zweiten Seite abzustrahlen.

**3.** Ein Verfahren gemäß Anspruch 1, bei dem die zweite vorgegebene Substanz eine Substanz mit einem größeren thermischen Emissionsvermögen ist.

**4.** Ein Verfahren gemäß Anspruch 3, bei dem die erste und die zweite vorgegebene Substanz die gleichen sind.

**5.** Ein Verfahren gemäß Anspruch 1, bei dem im besagten dritten Schritt die besagte wenigstens eine weitere Schicht wenigstens eine weitere Schicht aus der besagten vorgegebenen ersten Substanz enthält.

**6.** Ein Verfahren gemäß Anspruch 1, das weiterhin einen Zweite-Seite-Schritt der Erzeugung einer weiteren Schicht aus der vorgegebenen Substanz auf der auf der zweiten Seite des Substrates erzeugten Schicht mittels Dampfabscheidung umfaßt.

**7.** Ein Verfahren gemäß Anspruch 6, das weiterhin die Wiederholung des besagten Zweite-Seite-Schrittes umfaßt, bis eine Schicht in einer gewünschten Dicke auf der zweiten Seite erzeugt worden ist.

**8.** Ein Verfahren gemäß Anspruch 1, das weiterhin einen Schritt umfaßt, bei dem wenigstens einer der nachfolgenden Parameter variiert wird: die Dicke der Schicht auf der ersten Seite, die Dicke der Schicht auf der zweiten Seite, die Aufdampfrate auf die erste Seite und die Aufdampfrate auf die zweite Seite.

**9.** Ein Verfahren gemäß Anspruch 1, das weiterhin die Kühlung des Substrates durch thermische Abstrahlung vom Substrat zu einem Kühlelement umfaßt.

**10.** Ein Verfahren gemäß Anspruch 1, das weiterhin die Bewegung des Substrates auf der besagten frei beweglichen Aufdampfvorrichtung umfaßt.

**11.** Ein Verfahren gemäß Anspruch 10, das weiterhin eine Variation der Geschwindigkeit der Substratbewegung zur Steuerung der Substrattemperatur umfaßt.

**12.** Ein Verfahren gemäß Anspruch 10, das weiterhin die Kühlung durch Wärmeleitung vom Substrat zu einem Kühlelement der frei beweglichen Aufdampfvorrichtung umfaßt.

**13.** Ein Verfahren gemäß Anspruch 1, das weiterhin die Halterung des Substrates auf einer stationären Aufdampfvorrichtung umfaßt.

**14.** Ein Verfahren gemäß Anspruch 13, das weiterhin die Kühlung durch Wärmeleitung vom Substrat zu einem Kühlelement der stationären Aufdampfvorrichtung umfaßt.

**15.** Ein Verfahren gemäß Anspruch 1, bei dem die Dampfabscheidung einen reaktiven Aufdampfprozeß umfaßt.

**16.** Ein Verfahren gemäß Anspruch 1, bei dem die Metallfolie eine Aluminiumfolie ist.

**17.** Ein Verfahren gemäß Anspruch 1, bei dem der besagte Dampfabscheidungsprozeß aus einem der nachfolgenden Verfahren ausgewählt ist: reaktive Aluminium-Bedampfung, Aluminiumoxid-Bedampfung, reaktive Tantal-Bedampfung, Tantaloxid-Bedampfung, reaktive Titan-Bedampfung und Titanoxid-Bedampfung.

**18.** Ein Verfahren gemäß Anspruch 16, bei dem der besagte Dampfabscheidungsprozeß aus einem der nachfolgenden Verfahren ausgewählt ist: reaktive Aluminium-Bedampfung, Aluminiumoxid-Bedampfung, reaktive Tantal-Bedampfung, Tantaloxid-Bedampfung, reaktive Titan-Bedampfung und Titanoxid-Bedampfung.

## Revendications

**1.** Procédé de contrôle de la température d'un substrat (18) en feuille métallique à faible émittance thermique pendant un procédé de dépôt de vapeur sur lui, dans un appareil (10) de dépôt de vapeur sur portée libre, qui comprend:

(a) une première étape de formation, par dépôt de vapeur, d'une couche (40) d'une première substance présélectionnée sur une première face du substrat (18), ladite couche possédant une émittance thermique supérieure à celle du substrat,

(b) une seconde étape de formation, par dépôt de vapeur sur une seconde face du substrat (18), d'une couche (42) d'une seconde substance présélectionnée, la couche sur la première face servant à rayonner l'excès de chaleur hors du substrat (18), empêchant ainsi le chauffage du substrat (18) à une température supérieure à une température prédéterminée,

et, facultativement (c) une troisième étape de formation, par dépôt de vapeur sur la couche formée sur la première face du substrat (18), d'au moins une couche (44) supplémentaire d'une substance présélectionnée, jusqu'à ce qu'une couche d'une épaisseur souhaitée soit formée sur la première face,

**caractérisé en ce que** le dépôt de vapeur de la première étape (a) est choisi parmi un dépôt réactif de vapeur d'aluminium, dans lequel la vapeur comprend un mélange d'aluminium métallique et d'oxygène, un dépôt de vapeur d'oxyde d'aluminium, un dépôt réactif de vapeur de tantale, dans lequel la vapeur comprend un mélange de tantale métallique et d'oxygène, un dépôt de vapeur d'oxyde de tantale, un dépôt réactif de vapeur de titane dans lequel la vapeur comprend un mélange de titane métallique et d'oxygène, et un dépôt de vapeur d'oxyde de titane.

**2.** Procédé selon la revendication 1, dans lequel la couche sur la première face sert en outre à rayonner l'excès de chaleur hors de la couche sur la seconde face, en plus de rayonner la chaleur hors du substrat.

**3.** Procédé selon la revendication 1, dans lequel la seconde substance présélectionnée est une substance possédant une émittance thermique supérieure à celle du substrat.

**4.** Procédé selon la revendication 3, dans lequel la première et la seconde substances présélectionnées sont les mêmes.

**5.** Procédé selon la revendication 1, dans lequel, au cours de ladite troisième étape, ladite couche supplémentaire au moins présente comprend au moins une couche supplémentaire de ladite première substance présélectionnée.

**6.** Procédé selon la revendication 1, comprenant en outre une étape de seconde face pour former, par dépôt de vapeur sur la couche formée sur la seconde face du substrat, une couche supplémentaire de la substance présélectionnée.

**7.** Procédé selon la revendication 6, comprenant en outre une répétition de ladite étape de seconde face jusqu'à ce qu'une couche d'une épaisseur souhaitée soit formée sur la seconde face.

**8.** Procédé selon la revendication 1, comprenant en outre une étape consistant à faire varier au moins l'un des paramètres suivants: l'épaisseur de la couche sur la première face, l'épaisseur de la couche sur la seconde face, la vitesse de dépôt de vapeur sur la première face, et la vitesse de dépôt de vapeur sur la seconde face.

**9.** Procédé selon la revendication 1, comprenant en outre un refroidissement du substrat par rayonnement thermique du substrat vers un élément froid.

**10.** Procédé selon la revendication 1, comprenant en outre le déplacement du substrat sur l'appareil pour dépôt de vapeur sur portée libre.

**11.** Procédé selon la revendication 10, comprenant en outre une variation de la vitesse du substrat pour contrôler la température du substrat.

**12.** Procédé selon la revendication 10, comprenant en outre un refroidissement du substrat par conduction vers un élément froid de l'appareil à portée libre.

**13.** Procédé selon la revendication 1, comprenant en outre un support du substrat sur un appareil fixe pour le dépôt de vapeur.

**14.** Procédé selon la revendication 13, comprenant en outre un refroidissement du substrat par conduction vers un élément froid de l'appareil fixe.

**15.** Procédé selon la revendication 1, dans lequel le dépôt de vapeur comprend le dépôt de vapeur réactive.

**16.** Procédé selon la revendication 1, dans lequel la feuille métallique est une feuille d'aluminium

**17.** Procédé selon la revendication 1, dans lequel ledit dépôt de vapeur est choisi parmi un dépôt réactif de vapeur d'aluminium, un dépôt de vapeur d'oxyde d'aluminium, un dépôt réactif de vapeur de tantale, un dépôt de vapeur d'oxyde de tantale, un dépôt réactif de vapeur de titane et un dépôt de vapeur d'oxyde de titane.

**18.** Procédé selon la revendication 16, dans lequel ledit dépôt de vapeur est choisi parmi un dépôt réactif de vapeur d'aluminium, un dépôt de vapeur d'oxyde d'aluminium, un dépôt réactif de vapeur de tantale, un dépôt de vapeur d'oxyde de tantale, un dépôt réactif de vapeur de titane et un dépôt de vapeur d'oxyde de titane.

FIG.1

EP 1 390 157 B1

FIG.2

FIG.3

EP 1 390 157 B1

FIG.4A

FIG.4B

FIG.4C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4970626 A, Kakinoki
- US 5288515 A, Nakamura
- EP 0730045 A
- JP 59173266 B
- WO 8910430 A
- US 4844009 A

### Non-patent literature cited in the description

- **F. CASEY et al.** Properties of Metallized Film in a Free Span Web Metallizer. *Society of Vacuum Coaters 505/856-7188,* 1999, 480-483